# EUROPEAN PATENT SPECIFICATION

(11) **EP 4 148 989 B1**
(45) Date of publication and mention of the grant of the patent: **04.11.2026**
(21) Application number: 20939853.6
(22) Date of filing: 08.06.2020
(51) Int. Cl.: H03F 1/02, H03F 1/07, H03F 1/08, H03F 3/189, H03F 3/68

(54) **AMPLIFICATION CIRCUIT**
VERSTÄRKUNGSSCHALTUNG
CIRCUIT D'AMPLIFICATION

(43) Date of publication of application: 15.03.2023
(73) Proprietor: MITSUBISHI ELECTRIC CORPORATION, Chiyoda-ku Tokyo 100-8310 (JP)
(72) Inventor: SAKATA, Shuichi, Tokyo 100-8310 (JP); KOMATSUZAKI, Yuji, Tokyo 100-8310 (JP); SHINJO, Shintaro, Tokyo 100-8310 (JP)
(74) Representative: Pfenning, Meinig & Partner mbB
(86) International application number: PCT/JP2020/022456
(87) International publication number: WO 2021/250721

(56) References cited:
- WO-A1-2008/024729
- WO-A1-2017/122271
- JP-A- 2002 330 031
- JP-A- 2010 245 705
- JP-A- H1 056 339
- JP-B2- 3 423 706
- US-B1- 6 812 794
- US-B2- 10 530 306
- US-B2- 9 479 119
- ANONYMOUS: "Maximum power transfer theorem - Wikipedia", 22 January 2020 (2020-01-22), pages 1 - 6, XP093139773, Retrieved from the Internet <URL:https://en.wikipedia.org/w/index.php?title=Maximum_power_transfer_theorem&oldid=937038651> [retrieved on 20240311]
- ANONYMOUS: "Distributed-element circuit - Wikipedia", 27 October 2019 (2019-10-27), XP093322321, Retrieved from the Internet <URL:https://en.wikipedia.org/w/index.php?title=Distributed-element_circuit&oldid=923197309#cite_note-2>

## Description

### TECHNICAL FIELD

The present disclosure relates to an amplifier circuit that amplifies a signal.

### BACKGROUND ART

Among amplifier circuits, there are some amplifier circuits each of which includes a first amplifier and a second amplifier and each of in which the second amplifier is connected in series to an output side of the first amplifier.

In Patent Literature 1 below, an amplifier circuit in which a drive amplifier is used as a first amplifier and a Doherty amplifier is used as a second amplifier is disclosed. In the amplifier circuit, an impedance adjustment unit is connected between the drive amplifier and the Doherty amplifier.

The impedance adjustment unit includes a matching circuit that matches the output load impedance of the drive amplifier with the input impedance of the Doherty amplifier, and a phase adjuster that adjusts the phase of a signal outputted from the matching circuit to the Doherty amplifier. The phase adjuster's adjustment of the phase of the signal makes it possible to improve the efficiency of the drive amplifier when the output power of the Doherty amplifier is lower than saturation electric power.

### CITATION LIST

### PATENT LITERATURE

Patent Literature 1: JP 2014-116757 A US 9 479 119 B2 discloses an amplifier circuit capable of achieving high efficiency at back off power while maintaining high output power when an amplifier of a driving stage is saturated in a multistage amplifier in which a plurality of amplifiers are connected in series to each other. In the amplifier circuit, at least two amplifiers including a first amplifier and a second amplifier, the first amplifier preceding the second the first amplifier, are connected in series to each other, the second amplifier changes input impedance according to output power from the first amplifier, and an impedance adjusting unit for adjusting output load impedance of the first amplifier is disposed between the first amplifier and the second amplifier, wherein the impedance adjusting unit optimizes the output load impedance of the first amplifier according to a change of input impedance of the second amplifier.

US 6 812 794 B1 discloses that an inter-stage matching circuit comprises a one-stage high pass filter type matching unit and a one-stage low pass filter type matching unit serially connected with each other.

US 1 053 0306 B2 discloses that a hybrid power amplifier circuit includes a preliminary stage amplification device, a final stage amplification device, and intermediate circuitry at least indirectly coupling the preliminary stage amplification device and the final stage amplification device. The intermediate circuitry includes a low-pass circuit and a high-pass circuit, and the hybrid power amplifier circuit is configured to amplify a first signal component at a fundamental frequency. Due at least in part to the intermediate circuitry, a phase of a second signal component at a harmonic frequency that is a multiple of the fundamental frequency is shifted.**SUMMARY OF INVENTION**

### TECHNICAL PROBLEM

In the amplifier circuit disclosed in Patent Literature 1, the impedance adjustment unit includes the phase adjuster. The phase adjuster is a distributed constant circuit constituted by a transmission line. A problem with the amplifier circuit disclosed in Patent Literature 1 is that its circuit size is large because the amplifier circuit includes the phase adjuster constituted by a distributed constant circuit.

The present disclosure is made in order to solve the above-mentioned problem, and it is therefore an object of the present disclosure to obtain an amplifier circuit that makes it possible to improve the efficiency of a first amplifier when the output power of a second amplifier is lower than saturation electric power, without having to use a distributed constant circuit.

### SOLUTION TO PROBLEM

The invention is defined by the independent claims. Preferable embodiments are defined by the dependent claims.

According to the present disclosure, there is provided an amplifier circuit including: a first amplifier to amplify a signal to be amplified; an output matching circuit through which the signal amplified by the first amplifier propagates; and a second amplifier to amplify the signal which has propagated through the output matching circuit, in which the output matching circuit is a lumped constant circuit including multiple lumped constant elements, and, by using the multiple lumped constant elements, transforms impedance seen on a side of the second amplifier from the first amplifier when output power of the second amplifier is lower than saturation electric power, to impedance higher than impedance seen on the side of the second amplifier from the first amplifier when the output power of the second amplifier is equal to the saturation electric power. The output matching circuit, by using the multiple lumped constant elements, transforms the impedance seen on the side of the second amplifier from the first amplifier when the output power of the second amplifier is lower than the saturation electric power in such a way that an absolute value of a sum total of a transmission phase of a parasitic component included in the first amplifier, a transmission phase of the output matching circuit and an input reflection phase of the second amplifier is equal to or less than a threshold, wherein the threshold is equal to or greater than 0 and equal to or less than 45.

### ADVANTAGEOUS EFFECTS OF INVENTION

According to the present disclosure, the efficiency of the first amplifier when the output power of the second amplifier is lower than the saturation electric power can be improved without having to use a distributed constant circuit.

### BRIEF DESCRIPTION OF DRAWINGS

Fig. 1 is a block diagram showing an amplifier circuit according to Embodiment 1;
Fig. 2 is a schematic diagram showing a second amplifier 7 implemented by a Doherty amplifier;
Fig. 3 is an equivalent circuit diagram showing an equivalent circuit of a first amplifier 3 included in the amplifier circuit according to Embodiment 1;
Fig. 4 is a schematic diagram showing an example of a lumped constant element included in an LPF type matching circuit 5, and an example of lumped constant elements included in an HPF type matching circuit 6;
Fig. 5 is a Smith chart showing the input impedance Imp_{IN} of the second amplifier 7;
Fig. 6 is a Smith chart showing the impedance Imp_{OUT} seen on the second amplifier 7 side from the current source 22 of the first amplifier 3;
Fig. 7 is a Smith chart showing an example of impedance transformation by an output matching circuit 4;
Fig. 8 is an explanatory drawing showing the efficiency of the first amplifier 3 in the amplifier circuit shown in Fig. 1; and
Fig. 9 is a schematic diagram showing a second amplifier 7 implemented by an envelope tracking amplifier.

### DESCRIPTION OF EMBODIMENTS

Hereinafter, in order to explain the present disclosure in greater detail, embodiments of the present disclosure will be explained with reference to the accompanying drawings.

### Embodiment 1.

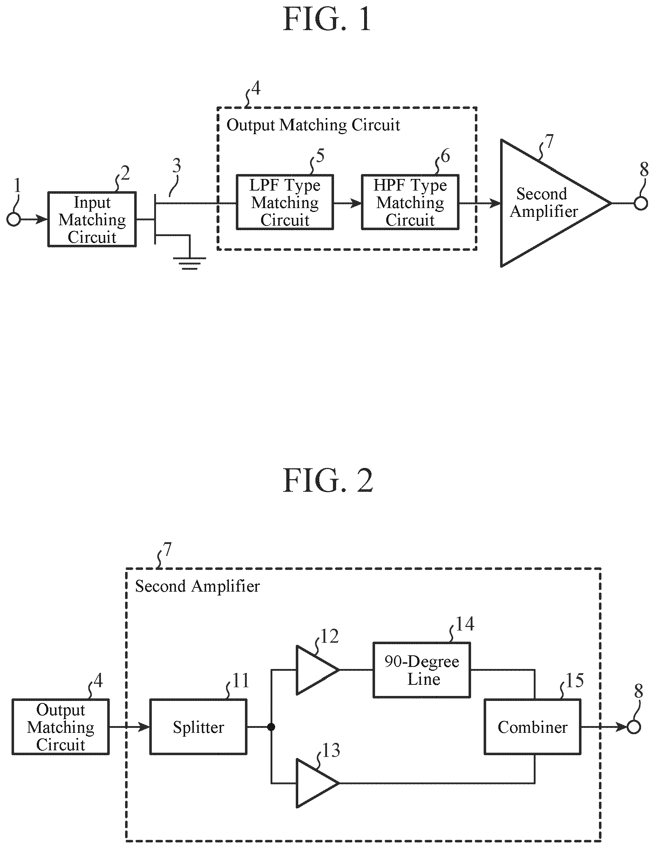

Fig. 1 is a block diagram showing an amplifier circuit according to Embodiment 1.

The amplifier circuit shown in Fig. 1 includes an input terminal 1, an input matching circuit 2, a first amplifier 3, an output matching circuit 4, a second amplifier 7 and an output terminal 8.

To the input terminal 1, a signal to be amplified is supplied.

One end of the input matching circuit 2 is connected to the input terminal 1.

The other end of the input matching circuit 2 is connected to an input side of the first amplifier 3.

The input matching circuit 2 is implemented by, for example, lumped constant elements.

The input matching circuit 2 matches the input impedance of the first amplifier 3 with the impedance of an input side of the amplifier circuit shown in Fig. 1.

The first amplifier 3 is implemented by, for example, a field effect transistor (FET), a heterojunction bipolar transistor (HBT) or a high electron mobility transistor (HEMT) .

The first amplifier 3 amplifies the signal to be amplified which has propagated through the input matching circuit 2, and outputs the amplified signal to the output matching circuit 4.

One end of the output matching circuit 4 is connected to an output side of the first amplifier 3.

The other end of the output matching circuit 4 is connected to an input side of the second amplifier 7.

The output matching circuit 4 is a lumped constant circuit having lumped constant elements.

More specifically, the output matching circuit 4 includes a low pass filter (LPF) type matching circuit 5 having a lumped constant element, and a high pass filter (HPF) type matching circuit 6 having lumped constant elements.

The output matching circuit 4 is the one through which the signal amplified by the first amplifier 3 propagates.

Using the multiple lumped constant elements, the output matching circuit 4 transforms the impedance seen on the second amplifier 7 side from the first amplifier 3 when the output power of the second amplifier 7 is lower than saturation electric power, to impedance higher than the impedance seen on the second amplifier 7 side from the first amplifier 3 when the output power of the second amplifier 7 is equal to the saturation electric power.

Because the output matching circuit 4 is the lumped constant circuit, its circuit size is smaller than that of an output matching circuit constituted by a distributed constant circuit.

One end of the LPF pattern matching circuit 5 is connected to the output side of the first amplifier 3.

The other end of the LPF pattern matching circuit 5 is connected to one end of the HPF pattern matching circuit 6.

The LPF pattern matching circuit 5 has an inductor as the lumped constant element, for example.

The one end of the HPF type matching circuit 6 is connected to the other end of the LPF type matching circuit 5.

The other end of the HPF type matching circuit 6 is connected to the input side of the second amplifier 7.

The HPF type matching circuit 6 has an inductor and capacitors as the lumped constant elements, for example.

The second amplifier 7 is implemented by, for example, a Doherty amplifier as shown in Fig. 2.

The second amplifier 7 amplifies the signal which has propagated through the output matching circuit 4.

The second amplifier 7 outputs the amplified signal to the output terminal 8.

The output terminal 8 is the one via which the signal amplified by the second amplifier 7 is outputted to the outside.

Fig. 2 is a schematic diagram showing the second amplifier 7 which is implemented by the Doherty amplifier.

The Doherty amplifier shown in Fig. 2 includes a splitter 11, a carrier amplifier 12, a peak amplifier 13, a 90-degree line 14 and a combiner 15.

The splitter 11 splits the signal which has propagated through the output matching circuit 4 into two signals, and outputs one of the signals to the carrier amplifier 12 and outputs the other signal to the peak amplifier 13.

The carrier amplifier 12 amplifies the one of the signals outputted from the splitter 11 and outputs the amplified signal to the 90-degree line 14.

When the signal level of the other signal outputted from the splitter 11 is higher than a constant level, the peak amplifier 13 amplifies this signal and outputs the amplified signal to the combiner 15.

The 90-degree line 14 is intended for making the electric length of a line on an output side of the carrier amplifier 12 equal to 90 degrees.

The combiner 15 combines the signal which has propagated through the 90-degree line 14 and the signal amplified by the peak amplifier 13, and outputs a composite signal of the two signals.

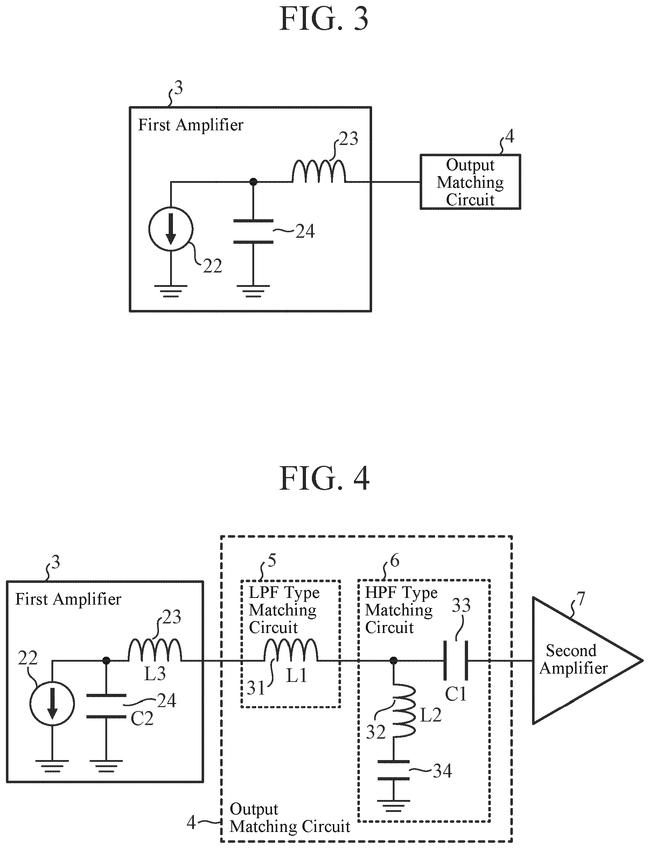

Fig. 3 is an equivalent circuit diagram showing an equivalent circuit of the first amplifier 3 included in the amplifier circuit according to Embodiment 1.

The equivalent circuit of the first amplifier 3 is represented by a current source 22, an inductor 23 and a capacitor 24, as shown in Fig. 3.

The current source 22 outputs a current which increases with increase in the signal level of the signal to be amplified which has propagated through the input matching circuit 2.

The inductor 23 is a part of a parasitic component from the current source 22 to one end of the LPF type matching circuit 5.

The capacitor 24 is a part of the parasitic component from the current source 22 to the one end of the LPF type matching circuit 5.

The parasitic component included in the first amplifier 3, i.e., the parasitic element from the current source 22 to the one end of the LPF type matching circuit 5 is represented by the inductor 23 and the capacitor 24.

Fig. 4 is a schematic diagram showing an example of the lumped constant element included in the LPF type matching circuit 5 and an example of the lumped constant elements included in the HPF type matching circuit 6.

The LPF type matching circuit 5 includes a first inductor 31 as the lumped constant element.

One end of the first inductor 31 is connected to the output side of the first amplifier 3.

The other end of the first inductor 31 is connected to each of one ends of a second inductor 32 and a capacitor 33 which are included in the HPF type matching circuit 6.

The HPF type matching circuit 6 includes the second inductor 32, the capacitor 33 and a direct current (DC) blocking capacitor 34 as the lumped constant elements.

The one end of the second inductor 32 is connected to each of the following ends: the other end of the first inductor 31 and one end of the capacitor 33.

The other end of the second inductor 32 is connected to one end of the DC blocking capacitor 34.

The one end of the capacitor 33 is connected to each of the following ends: the other end of the first inductor 31 and the one end of the second inductor 32.

The other end of the capacitor 33 is connected to the input side of the second amplifier.

The one end of the DC blocking capacitor 34 is connected to the other end of the second inductor 32.

The other end of the DC blocking capacitor 34 is grounded.

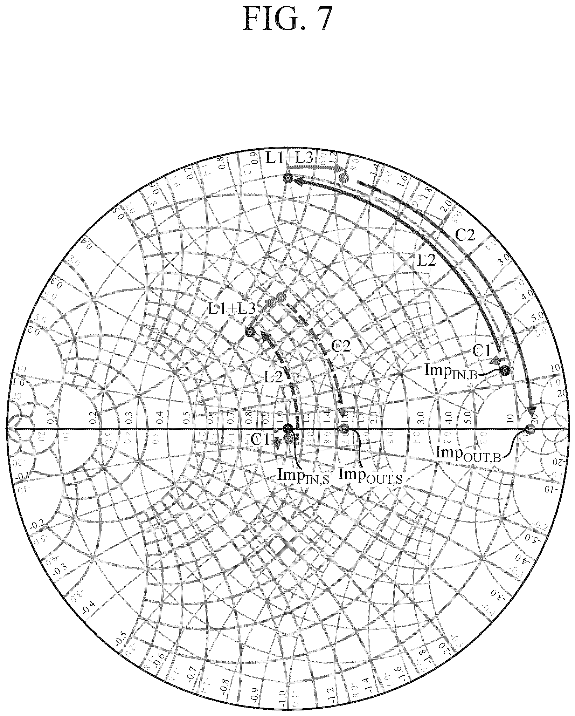

The HPF type matching circuit 6 shown in Fig. 7 includes the DC blocking capacitor 34. However, this is only an example, and the HPF type matching circuit 6 may not include the DC blocking capacitor 34 and the other end of the second inductor 32 may be grounded.

Next, the operation of the amplifier circuit shown in Fig. 1 will be explained.

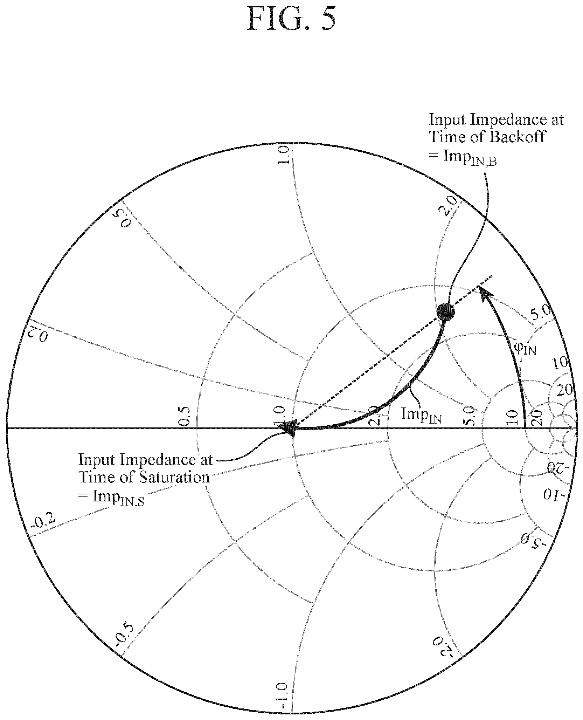

The second amplifier 7 is implemented by the Doherty amplifier as shown in Fig. 2. Therefore, the input impedance Imp_{IN} of the second amplifier 7 varies during a time period from a time of backoff to a time of saturation, as shown in Fig. 5.

Here, the time of saturation shows a state in which the output power of the second amplifier 7 is equal to the saturation electric power.

The time of backoff shows a state in which the output power of the second amplifier 7 is lower than the saturation electric power, and in which the peak amplifier 13 can perform a signal amplification operation.

Fig. 5 is a Smith chart showing the input impedance Imp_{IN} of the second amplifier 7.

In the Smith chart shown in Fig. 5, the input impedance Imp_{IN,S} of the second amplifier 7 at the time of saturation is shown at the center of the Smith chart.

The input impedance of the second amplifier 7 at the time of backoff is Imp_{IN,B}, as shown in Fig. 5, and the input reflection phase of the second amplifier 7 at the time of backoff is ϕ_{IN}, as shown in Fig. 5. The absolute value of the input reflection phase ϕ_{IN} of the second amplifier 7 at the time of backoff is larger than zero.

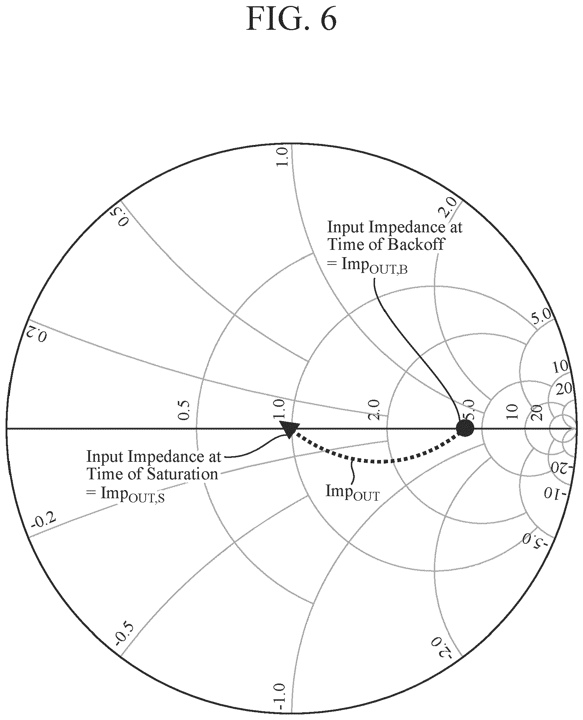

Fig. 6 is a Smith chart showing the impedance Imp_{OUT} seen on the second amplifier 7 side from the current source 22 of the first amplifier 3.

The impedance Imp_{OUT} varies during the time period from the time of backoff of the second amplifier 7 to the time of saturation of the second amplifier 7, as shown in Fig. 6.

In the Smith chart shown in Fig. 6, the impedance Imp_{OUT,S} at the time of saturation is shown at the center of the Smith chart. When the impedance Imp_{OUT} seen on the second amplifier 7 side from the current source 22 is the impedance Imp_{OUT,S} at the time of saturation, the output power of the first amplifier 3 is the maximum power. More specifically, the output power of the first amplifier 3 is equal to the saturation electric power.

Because the input impedance Imp_{IN} of the second amplifier 7 varies during the time period from the time of backoff to the time of saturation, the impedance Imp_{OUT} seen on the second amplifier 7 side from the current source 22 also varies during the time period from the time of backoff to the time of saturation. The impedance at the time of backoff is Imp_{OUT,B}.

It is possible to transform the input impedance Imp_{IN,S} of the second amplifier 7 at the time of saturation, by modifying the lumped constant elements included in the output matching circuit 4.

In the amplifier circuit shown in Fig. 1, the lumped constant elements included in the output matching circuit 4 are designed in such a way that the input impedance Imp_{IN,S} of the second amplifier 7 at the time of saturation is transformed, by the output matching circuit 4, to the impedance Imp_{OUT,S} at which the output power of the first amplifier 3 is the maximum power.

In the case where the lumped constant elements included in the output matching circuit 4 are designed in the above-mentioned way, the impedance Imp_{OUT} seen on the second amplifier 7 side from the current source 22 is matched with the impedance Imp_{OUT,S} at which the output power of the first amplifier 3 is the maximum power.

It is possible to transform the input impedance Imp_{IN,B} of the second amplifier 7 at the time of backoff, by modifying the lumped constant elements included in the output matching circuit 4.

In the amplifier circuit shown in Fig. 1, the lumped constant elements included in the output matching circuit 4 are designed in such a way that the impedance Imp_{OUT,B} seen on the second amplifier 7 side from the current source 22 at the time of backoff is transformed, by the output matching circuit 4, to impedance higher than the impedance Imp_{OUT,S} seen on the second amplifier 7 side from the current source 22 at the time of saturation.

Concretely, the lumped constant elements included in the output matching circuit 4 are designed in such a way that the absolute value of the sum total of the transmission phase ϕ_{PAR} of the parasitic component from the current source 22 to the one end of the output matching circuit 4, the transmission phase ϕ_{LPF} of the LPF type matching circuit 5, the transmission phase ϕ_{HPF} of the HPF type matching circuit 6 and the input reflection phase ϕ_{IN} of the second amplifier 7 is equal to or less than a threshold Th. The threshold Th is assumed to be equal to or greater than 0 and equal to or less than 45, for example.

For example, in a case where 0 is used as the threshold Th, and where the lumped constant elements included in the output matching circuit 4 are designed in such a way that the absolute value of the sum total is 0 degrees, the input reflection phase ϕ_{IN} of the second amplifier 7 is transformed to 0 degrees, and the efficiency of the first amplifier 3 when the second amplifier 7 performs a backoff operation has a maximum.

Fig. 7 is a Smith chart showing an example of the impedance transformation by the output matching circuit 4.

In Fig. 7, it is assumed that the input impedance Imp_{IN,S} of the second amplifier 7 at the time of saturation is 50Q, and the impedance Imp_{OUT,S} at which the output power of the first amplifier 3 is the maximum power is 75Ω.

L1 denotes the inductance of the first inductor 31, L2 denotes the inductance of the second inductor 32, and L3 denotes the inductance of the inductor 23 which is a part of the parasitic component.

C1 denotes the capacitance of the capacitor 33, and C2 denotes the capacitance of the capacitor 24 which is a part of the parasitic component.

In the Smith chart shown in Fig. 7, the input impedance Imp_{IN,S} of the second amplifier 7 at the time of saturation is shown at the center of the Smith chart.

Further, in the Smith chart shown in Fig. 7, the impedance transformation at the time of saturation is expressed by a dotted line, and the impedance transformation at the time of backoff is expressed by a solid line.

At the time of saturation of the second amplifier 7, the input impedance Imp_{IN,S} of the second amplifier 7 is transformed, by C1, L2, L1+L3 and C2, to 75Ω which is the impedance Imp_{OUT,S} at which the output power of the first amplifier 3 is the maximum power (see the dotted line of Fig. 7).

At the time of backoff of the second amplifier 7, the input impedance Imp_{IN,B} of the second amplifier 7 is transformed, by C1, L2, L1+L3 and C2, to the impedance Imp_{OUT,B} higher than the impedance Imp_{OUT,S} at which the output power of the first amplifier 3 is the maximum power (see the solid line of Fig. 7). The impedance Imp_{OUT,B} is on the real axis of the Smith chart, as shown in Fig. 7.

At the time of backoff of the second amplifier 7, the input impedance Imp_{IN,B} of the second amplifier 7 is transformed to the impedance Imp_{OUT,B} higher than the impedance Imp_{OUT,S} at which the output power of the first amplifier 3 is the maximum power. Further, the input impedance Imp_{IN,B} of the second amplifier 7 is transformed onto the real axis of the Smith chart. Therefore, a high-efficiency operation of the first amplifier 3 at the time of backoff can be implemented.

Therefore, in the amplifier circuit shown in Fig. 1, when the inductances L1 and L2 and the capacitance C1 are designed on the basis of the inductance L3 and the capacitance C2 in such a way that the Smith chart shown in Fig. 7 is applied, a high-efficiency operation of the first amplifier 3 at the time of backoff can be implemented while the maximum output power of the first amplifier 3 at the time of saturation is maintained.

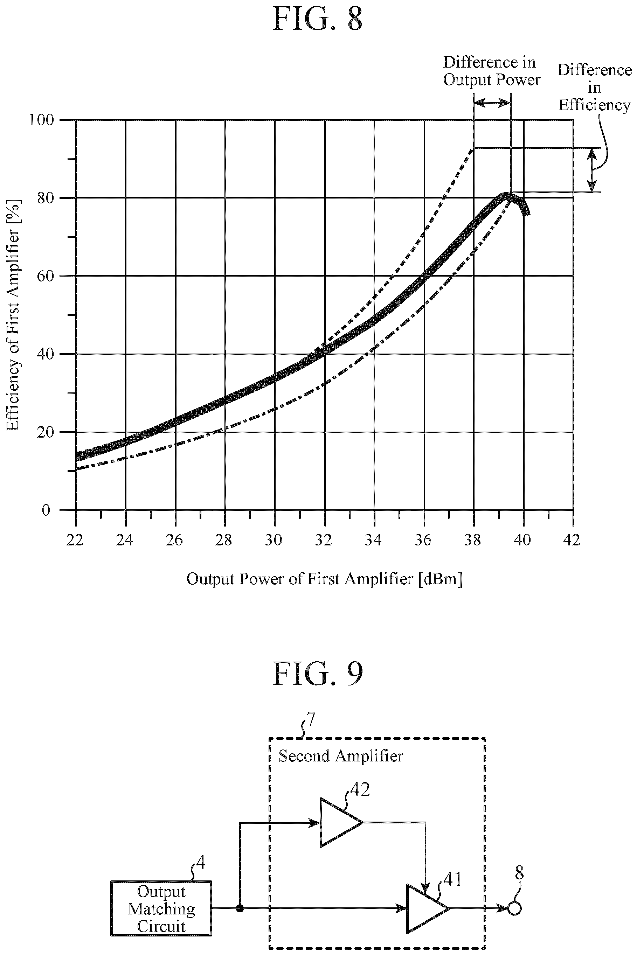

Fig. 8 is an explanatory drawing showing the efficiency of the first amplifier 3 in the amplifier circuit shown in Fig. 1.

In Fig. 8, the horizontal axis shows the output power [dBm] of the first amplifier 3, and the vertical axis shows the efficiency [%] of the first amplifier 3.

In Fig. 8, the efficiency characteristic of the first amplifier 3 in the amplifier circuit shown in Fig. 1 is expressed by a solid line. In Fig. 8, the efficiency characteristic of the first amplifier 3 when 0 is used as the threshold Th and the lumped constant elements included in the output matching circuit 4 are designed in such a way that the absolute value of the sum total is 0 degrees is shown.

A dotted line shows the efficiency characteristic of the first amplifier 3 (referred as the "first assumptive efficiency characteristic" hereinafter) when it is assumed that the impedance Imp_{OUT} seen on the second amplifier 7 side from the current source 22 is fixed to the input impedance Imp_{IN,B} of the second amplifier 7 at the time of backoff. The time of backoff here shows a state in which the signal level of a signal outputted from the splitter 11 is the lowest signal level, out of states in which the peak amplifier 13 can perform a signal amplification operation.

An alternate long and short dash line shows the efficiency characteristic of the first amplifier 3 (referred as the "second assumptive efficiency characteristic" hereafter) when it is assumed that the impedance Imp_{OUT} seen on the second amplifier 7 side from the current source 22 is fixed to the input impedance Imp_{IN,S} of the second amplifier 7 at the time of saturation.

The impedance Imp_{OUT,B} seen on the second amplifier 7 side from the current source 22 at the time of backoff is higher than the impedance Imp_{OUT,S} at the time of saturation. Therefore, the output power of the first amplifier 3 at the time of backoff is lower than that of the first amplifier 3 at the time of saturation, and the efficiency of the first amplifier 3 at the time of backoff is higher than that of the first amplifier 3 at the time of saturation.

Because the impedance Imp_{OUT} seen on the second amplifier 7 side from the current source 22 varies during the time period from the time of backoff to the time of saturation, the efficiency characteristic of the first amplifier 3 overlaps with the first assumptive efficiency characteristic shown by the dotted line at the time of backoff, and the efficiency characteristic of the first amplifier 3 overlaps with the second assumptive efficiency characteristic shown by the alternate long and short dash line at the time of saturation.

Therefore, the efficiency of the first amplifier 3 at the time of backoff is higher than the efficiency shown by the second assumptive efficiency characteristic.

The output power at the time of saturation of the first amplifier 3 is greater than the output power shown by the first assumptive efficiency characteristic.

In Fig. 8, the efficiency characteristic of the first amplifier 3 when 0 is used as the threshold Th and the lumped constant elements included in the output matching circuit 4 are designed in such a way that the absolute value of the sum total is 0 degrees is shown.

The efficiency characteristic of the first amplifier 3 when 45 is used as the threshold Th and the lumped constant elements included in the output matching circuit 4 are designed in such a way that the absolute value of the sum total is 45 degrees is lower than that of the first amplifier 3 when the lumped constant elements included in the output matching circuit 4 are designed in such a way that the absolute value of the sum total is 0 degrees.

However, the efficiency characteristic of the first amplifier 3 at the time of backoff when the lumped constant elements included in the output matching circuit 4 are designed in such a way that the absolute value of the sum total is 45 degrees is between the first assumptive efficiency characteristic shown by the dotted line and the second assumptive efficiency characteristic shown by the alternate long and short dash line. Therefore, even in the case where the lumped constant elements included in the output matching circuit 4 are designed in such a way that the absolute value of the sum total is 45 degrees, the efficiency of the first amplifier 3 at the time of backoff of is higher than the efficiency shown by the second assumptive efficiency characteristic.

Note that the efficiency characteristic of the first amplifier 3 when 90 is used as the threshold Th and the lumped constant elements included in the output matching circuit 4 are designed in such a way that the absolute value of the sum total is 90 degrees overlaps with the second assumptive efficiency characteristic shown by the alternate long and short dash line, so that a high-efficiency operation at the time of backoff cannot be implemented.

In above-mentioned Embodiment 1, the amplifier circuit is configured in such a way that the amplifier circuit includes: the first amplifier 3 to amplify a signal to be amplified; the output matching circuit 4 through which the signal amplified by the first amplifier 3 propagates; and the second amplifier 7 to amplify the signal which has propagated through the output matching circuit 4, and the output matching circuit 4 is a lumped constant circuit including multiple lumped constant elements, and, by using the multiple lumped constant elements, transforms the impedance seen on the second amplifier 7 side from the first amplifier 3 when the output power of the second amplifier 7 is lower than the saturation electric power, to impedance higher than the impedance seen on the second amplifier 7 side from the first amplifier 3 when the output power of the second amplifier 7 is equal to the saturation electric power. Therefore, the amplifier circuit makes it possible to improve the efficiency of the first amplifier 3 when the output power of the second amplifier 7 is lower than the saturation electric power, without having to use a distributed constant circuit.

In the amplifier circuit shown in Fig. 1, the output matching circuit 4 includes the first inductor 31, the second inductor 32 and the capacitor 33 as the multiple lumped constant elements. The impedance Imp_{OUT,B} at the time of backoff is transformed, by the first inductor 31, the second inductor 32 and the capacitor 33, to impedance higher than the impedance Imp_{OUT,S} at the time of saturation.

However, what is necessary is just to be able to transform the impedance Imp_{OUT,B} at the time of backoff to impedance higher than the impedance Imp_{OUT,S} at the time of saturation, and the output matching circuit 4 is not limited to the one including the first inductor 31, the second inductor 32 and the capacitor 33 as the multiple lumped constant elements.

More specifically, the output matching circuit 4 should just include lumped constant elements which make the transmission phase of the output matching circuit 4 be ϕ_{LPF}+ϕ_{HPF}. Therefore, the output matching circuit 4 may provide the transmission phase ϕ_{LPF}+ϕ_{HPF} by including a combination of any lumped constant elements out of a series inductor, a parallel inductor, a series capacitor, a parallel capacitor, a series resistor, and a parallel resistor.

### Embodiment 2.

In the amplifier circuit shown in Fig. 1, the second amplifier 7 is implemented by a Doherty amplifier.

In Embodiment 2, an amplifier circuit in which a second amplifier 7 is implemented by an envelope tracking amplifier will be explained.

The configuration of the amplifier circuit according to Embodiment 2 is the same as that of the amplifier circuit according to Embodiment 1, and a schematic diagram showing the amplifier circuit according to Embodiment 2 is Fig. 1.

The envelope tracking amplifier is an amplifier whose input impedance Imp_{IN} varies, like Doherty amplifiers. Input impedance Imp_{IN,S} at a time of saturation in the envelope tracking amplifier and input impedance Imp_{IN,B} at a time of backoff in the envelope tracking amplifier are different from each other.

Fig. 9 is a schematic diagram showing the second amplifier 7 implemented by the envelope tracking amplifier.

The envelope tracking amplifier which is the second amplifier 7 includes a high frequency amplifier 41 and a power supply modulator 42.

The high frequency amplifier 41 amplifies a signal which has propagated through an output matching circuit 4.

The high frequency amplifier 41 outputs the amplified signal to an output terminal 8.

The power supply modulator 42 supplies a power supply voltage corresponding to the amplitude of the signal which has propagated through the output matching circuit 4 to the high frequency amplifier 41.

The power supply voltage supplied from the power supply modulator 42 to the high frequency amplifier 41 varies dependently on a variation in the amplitude of the signal which has propagated through the output matching circuit 4.

In the high frequency amplifier 41, the input impedance Imp_{IN} varies because the power supply voltage supplied from the power supply modulator 42 varies.

In above-mentioned Embodiment 2, the amplifier circuit is configured in such a way that the second amplifier 7 is implemented by the envelope tracking amplifier. The amplifier circuit according to Embodiment 2 makes it possible to improve the efficiency of a first amplifier 3 when the output power of the second amplifier 7 is lower than saturation electric power, without having to use a distributed constant circuit, like the amplifier circuit according to Embodiment 1.

### INDUSTRIAL APPLICABILITY

The present disclosure is suitable for an amplifier circuit that amplifies a signal.

### REFERENCE SIGNS LIST

1 input terminal, 2 input matching circuit, 3 first amplifier, 4 output matching circuit, 5 LPF type matching circuit, 6 HPF type matching circuit, 7 second amplifier, 8 output terminal, 11 splitter, 12 carrier amplifier, 13 peak amplifier, 14 90-degree line, 15 combiner, 21 transistor, 22 current source, 23 inductor, 24 capacitor, 31 first inductor, 32 second inductor, 33 capacitor, 34 direct current (DC) blocking capacitor, 41 high frequency amplifier, and 42 power supply modulator.

## Claims

1. An amplifier circuit comprising:
a first amplifier (3) to amplify a signal to be amplified;
an output matching circuit (4) through which the signal amplified by the first amplifier (3) propagates; and
a second amplifier (7) to amplify the signal which has propagated through the output matching circuit (4), wherein
the output matching circuit (4) is a lumped constant circuit including multiple lumped constant elements, and, by using the multiple lumped constant elements, transforms impedance seen on a side of the second amplifier (7) from the first amplifier (3) when output power of the second amplifier (7) is lower than saturation electric power, to impedance higher than impedance seen on the side of the second amplifier (7) from the first amplifier (3) when the output power of the second amplifier (7) is equal to the saturation electric power;
**characterized in that**
the output matching circuit (4), by using the multiple lumped constant elements, transforms the impedance seen on the side of the second amplifier (7) from the first amplifier (3) when the output power of the second amplifier (7) is lower than the saturation electric power in such a way that an absolute value of a sum total of a transmission phase of a parasitic component included in the first amplifier (3), a transmission phase of the output matching circuit (4) and an input reflection phase of the second amplifier (7) is equal to or less than a threshold;
wherein the threshold is equal to or greater than 0 and equal to or less than 45;
wherein the output matching circuit (4) comprises a low pass filter (LPF) type matching circuit (5) having a lumped constant element and a high pass filter (HPF) type matching circuit (6) having lumped constant elements;
wherein no distributed constant circuit, and in particular no transmission line, is interconnected between an output side of the first amplifier (3) and an input side of the second amplifier (7),
wherein the LPF type matching circuit (5) includes a first inductor (31) as the lumped constant element, the HPF type matching circuit (6) includes a second inductor (32), a capacitor (33), and a direct current (DC) blocking capacitor (34) as the lumped constant elements,
wherein one end of the first inductor (31) is connected to the output side of the first amplifier (3), the other end of the first inductor (31) is connected to each of one end of the second inductor (32) and one end of the capacitor (33), the one end of the second inductor (32) is connected to each of the other end of the first inductor (31) and the one end of the capacitor (33), the other end of the second inductor (32) is connected to one end of the DC blocking capacitor (34), the one end of the capacitor (33) is connected to each of the other end of the first inductor (31) and the one end of the second inductor (32), and the other end of the capacitor (33) is connected to the input side of the second amplifier (7).

2. The amplifier circuit according to claim 1, wherein the threshold is 45 degrees, and, the output matching circuit (4), by using the multiple lumped constant elements, transforms the impedance seen on the side of the second amplifier (7) from the first amplifier (3) when the output power of the second amplifier (7) is lower than the saturation electric power in such a way that the absolute value of the sum total is equal to or less than 45 degrees.

3. The amplifier circuit according to claim 1, wherein the threshold is 0 degrees, and, the output matching circuit (4), by using the multiple lumped constant elements, transforms the impedance seen on the side of the second amplifier (7) from the first amplifier (3) when the output power of the second amplifier (7) is lower than the saturation electric power in such a way that the absolute value of the sum total is equal to 0 degrees.

4. The amplifier circuit according to claim 1, wherein the second amplifier (7) is a Doherty amplifier.

5. The amplifier circuit according to claim 1, wherein the second amplifier (7) is an envelope tracking amplifier.

## Patentansprüche

1. Verstärkerschaltung, umfassend:
einen ersten Verstärker (3) zum Verstärken eines zu verstärkenden Signals;
eine Ausgangsanpassungsschaltung (4), durch die das vom ersten Verstärker (3) verstärkte Signal hindurchtritt; und
einen zweiten Verstärker (7) zum Verstärken des Signals, das durch die Ausgangsanpassungsschaltung (4) hindurchgetreten ist, wobei
die Ausgangsanpassungsschaltung (4) eine Schaltung mit konzentrierten Konstanten ist, die mehrere Elemente mit konzentrierten Konstanten umfasst, und unter Verwendung der mehreren konzentrierten Elemente eine Impedanz, die auf der Seite des zweiten Verstärkers (7) vom ersten Verstärker (3) gesehen wird, wenn eine Ausgangsleistung des zweiten Verstärkers (7) geringer ist als eine elektrische Sättigungsleistung, in eine Impedanz umwandelt, die höher ist als die Impedanz, die auf der Seite des zweiten Verstärkers (7) vom ersten Verstärker (3) gesehen wird, wenn die Ausgangsleistung des zweiten Verstärkers (7) der elektrischen Sättigungsleistung entspricht;
**dadurch gekennzeichnet, dass**
die Ausgangsanpassungsschaltung (4) unter Verwendung mehrerer Elemente mit konzentrierten Konstanten die Impedanz, die auf der Seite des zweiten Verstärkers (7) vom ersten Verstärker (3) gesehen wird, wenn die Ausgangsleistung des zweiten Verstärkers (7) geringer ist als die elektrische Sättigungsleistung, derart wandelt, dass ein Absolutwert einer Summe aus einer Übertragungsphase einer im ersten Verstärker (3) enthaltenen parasitären Komponente, einer Übertragungsphase der Ausgangsanpassungsschaltung (4) sowie einer Eingangsreflexionsphase des zweiten Verstärkers (7) gleich oder kleiner als ein Schwellenwert ist;
wobei der Schwellenwert größer oder gleich 0 und kleiner oder gleich 45 ist;
wobei die Ausgangsanpassungsschaltung (4) eine Anpassungsschaltung (5) vom Tiefpassfiltertyp (LPF) mit einem Element mit konzentrierten Parametern und eine Anpassungsschaltung (6) eines Hochpassfiltertyps (HPF) mit Elementen mit konzentrierten Parametern umfasst;
wobei zwischen der Ausgangsseite des ersten Verstärkers (3) und der Eingangsseite des zweiten Verstärkers (7) keine Schaltung mit verteilten Konstanten und insbesondere keine Übertragungsleitung verschaltet ist,
wobei die Anpassungsschaltung vom LPF-Typ (5) eine erste Induktivität (31) als konzentriertes Element umfasst, die Anpassungsschaltung vom HPF-Typ (6) eine zweite Induktivität (32), einen Kondensator (33) und einen Gleichstrom-Sperrkondensator (34) als konzentrierte Elemente umfasst,
wobei ein Ende der ersten Induktivität (31) mit der Ausgangsseite des ersten Verstärkers (3) verbunden ist, das andere Ende der ersten Induktivität (31) jeweils mit einem Ende der zweiten Induktivität (32) und einem Ende des Kondensators (33) verbunden ist, das eine Ende der zweiten Induktivität (32) sowohl mit dem anderen Ende der ersten Induktivität (31) als auch mit dem einen Ende des Kondensators (33) verbunden ist; das andere Ende der zweiten Induktivität (32) mit einem Ende des Gleichstrom-Sperrkondensators (34) verbunden ist, das eine Ende des Kondensators (33) sowohl mit dem anderen Ende der ersten Induktivität (31) als auch mit dem einen Ende der zweiten Induktivität (32) verbunden ist, und das andere Ende des Kondensators (33) mit der Eingangsseite des zweiten Verstärkers (7) verbunden ist.

2. Verstärkerschaltung nach Anspruch 1, wobei der Schwellenwert 45 Grad beträgt und, wenn die Ausgangsleistung des zweiten Verstärkers (7) geringer ist als die elektrische Sättigungsleistung, die Ausgangsanpassungsschaltung (4) unter Verwendung der mehreren Elemente mit konzentrierten Konstanten die Impedanz, die auf der Seite des zweiten Verstärkers (7) vom ersten Verstärker (3) gesehen wird, so umwandelt, dass der Absolutwert der Gesamtsumme gleich oder kleiner als 45 Grad ist.

3. Verstärkerschaltung nach Anspruch 1, wobei der Schwellenwert 0 Grad beträgt und, wenn die Ausgangsleistung des zweiten Verstärkers (7) geringer ist als die elektrische Sättigungsleistung, die Ausgangsanpassungsschaltung (4) unter Verwendung der mehreren Elemente mit konzentrierten Konstanten die Impedanze, die auf der Seite des zweiten Verstärkers (7) vom ersten Verstärker (3) gesehen wird, so umwandelt, dass der Absolutwert der Gesamtsumme 0 Grad beträgt.

4. Verstärkerschaltung nach Anspruch 1, wobei der zweite Verstärker (7) ein Doherty-Verstärker ist.

5. Verstärkerschaltung nach Anspruch 1, wobei der zweite Verstärker (7) ein Hüllkurvenverfolgungsverstärker ist.

## Revendications

1. Un circuit amplificateur comprenant :
un premier amplificateur (3) destiné à amplifier un signal à amplifier ;
un circuit d'adaptation de sortie (4) à travers lequel le signal amplifié par le premier amplificateur (3) se propage ; et
un second amplificateur (7) destiné à amplifier le signal qui s'est propagé à travers le circuit d'adaptation de sortie (4), dans lequel
le circuit d'adaptation de sortie (4) est un circuit à constantes localisées incluant de multiples éléments à constantes localisées, et, en utilisant les multiples éléments à constantes localisées, transforme une impédance vue du côté du second amplificateur (7) depuis le premier amplificateur (3) lorsque la puissance de sortie du second amplificateur (7) est inférieure à une puissance électrique de saturation, en une impédance supérieure à une impédance vue du côté du second amplificateur (7) depuis le premier amplificateur (3) lorsque la puissance de sortie du second amplificateur (7) est égale à la puissance électrique de saturation ;
**caractérisé en ce que**
le circuit d'adaptation de sortie (4), en utilisant les multiples éléments à constantes localisées, transforme l'impédance vue du côté du second amplificateur (7) depuis le premier amplificateur (3) lorsque la puissance de sortie du second amplificateur (7) est inférieure à la puissance électrique de saturation de telle sorte qu'une valeur absolue d'une somme totale d'une phase de transmission d'un composant parasite inclus dans le premier amplificateur (3), d'une phase de transmission du circuit d'adaptation de sortie (4) et d'une phase de réflexion d'entrée du second amplificateur (7) est égale ou inférieure à un seuil ;
dans lequel le seuil est supérieur ou égal à 0 et inférieur ou égal à 45 ;
dans lequel le circuit d'adaptation de sortie (4) comprend un circuit d'adaptation de type filtre passe-bas (LPF) (5) ayant un élément à constantes localisées et un circuit d'adaptation de type filtre passe-haut (HPF) (6) ayant des éléments à constantes localisées ;
dans lequel aucun circuit à constantes réparties, et en particulier aucune ligne de transmission, n'est interconnecté entre un côté sortie du premier amplificateur (3) et un côté entrée du second amplificateur (7),
dans lequel le circuit d'adaptation de type LPF (5) inclut un premier inducteur (31) en tant qu'élément à constantes localisées, le circuit d'adaptation de type HPF (6) inclut un second inducteur (32), un condensateur (33), et un condensateur de blocage de courant continu (CC) (34) en tant qu'éléments à constantes localisées,
dans lequel une extrémité du premier inducteur (31) est connectée au côté sortie du premier amplificateur (3), l'autre extrémité du premier inducteur (31) est connectée à chacune d'une extrémité du second inducteur (32) et d'une extrémité du condensateur (33), ladite extrémité du second inducteur (32) est connectée à chacune de l'autre extrémité du premier inducteur (31) et de ladite extrémité du condensateur (33), l'autre extrémité du second inducteur (32) est connectée à une extrémité du condensateur de blocage de CC (34), ladite extrémité du condensateur (33) est connectée à chacune de l'autre extrémité du premier inducteur (31) et de ladite extrémité du second inducteur (32), et l'autre extrémité du condensateur (33) est connectée au côté entrée du second amplificateur (7).

2. Le circuit amplificateur selon la revendication 1, dans lequel le seuil est de 45 degrés, et, le circuit d'adaptation de sortie (4), en utilisant les multiples éléments à constantes localisées, transforme l'impédance vue du côté du second amplificateur (7) depuis le premier amplificateur (3) lorsque la puissance de sortie du second amplificateur (7) est inférieure à la puissance électrique de saturation de telle sorte que la valeur absolue de la somme totale est égale ou inférieure à 45 degrés.

3. Le circuit amplificateur selon la revendication 1, dans lequel le seuil est de 0 degrés, et, le circuit d'adaptation de sortie (4), en utilisant les multiples éléments à constantes localisées, transforme l'impédance vue du côté du second amplificateur (7) depuis le premier amplificateur (3) lorsque la puissance de sortie du second amplificateur (7) est inférieure à la puissance électrique de saturation de telle sorte que la valeur absolue de la somme totale est égale à 0 degrés.

4. Le circuit amplificateur selon la revendication 1, dans lequel le second amplificateur (7) est un amplificateur Doherty.

5. Le circuit amplificateur selon la revendication 1, dans lequel le second amplificateur (7) est un amplificateur à suivi d'enveloppe.
